(19) Europäisches Patentamt
European Patent Office
Office européen des brevets

(11) **EP 2 887 544 A1**

(12) **EUROPEAN PATENT APPLICATION**
published in accordance with Art. 153(4) EPC

(43) Date of publication:
**24.06.2015 Bulletin 2015/26**

(51) Int Cl.:
*H03G 3/30* (2006.01)   *H03G 3/20* (2006.01)
*H04N 5/44* (2011.01)

(21) Application number: **13830972.9**

(22) Date of filing: **12.07.2013**

(86) International application number:
**PCT/JP2013/069119**

(87) International publication number:
**WO 2014/030460 (27.02.2014 Gazette 2014/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **20.08.2012   JP 2012181441**

(71) Applicant: **Sony Corporation
Tokyo 108-0075 (JP)**

(72) Inventors:
• **SHIMIZU, Hiroyuki
  Tokyo 108-0075 (JP)**
• **SHIMIZU, Yasuhiro
  Tokyo 108-0075 (JP)**
• **IKEDA, Mitsuru
  Tokyo 108-0075 (JP)**

(74) Representative: **Müller Hoffmann & Partner
Patentanwälte mbB
St.-Martin-Strasse 58
81541 München (DE)**

(54)   **RECEPTION DEVICE AND RECEPTION METHOD**

(57)   Provided is a reception device including a high-frequency reception processing unit that converts a high frequency signal into an intermediate frequency signal or a baseband signal, and an amplitude limiting unit that limits a first amplitude to a second amplitude, the first amplitude being an amplitude of the intermediate frequency signal or the baseband signal outputted from the high-frequency reception processing unit, the second amplitude being an amplitude allowable in a demodulation unit that demodulates the intermediate frequency signal or the baseband signal.

**FIG. 4**

EP 2 887 544 A1

**Description**

Technical Field

The present disclosure relates to a reception device and a reception method each of which receives a signal of a broadcast wave or the like, and particularly relates to a technique of performing control in a manner that a signal inputted to a demodulator has an appropriate amplitude.

Background Art

Conventionally, in a reception device such as a television receiver, analog/digital (A/D) conversion processing for converting a received analog signal into a digital signal is performed in demodulation processing for demodulating a reception signal. In recent years, definition of television broadcasting has been improved, and an A/D converter for performing the A/D conversion processing has been required to have a high resolution. A high-resolution A/D converter has a high sensitivity, so that, even when a small noise is flown or a voltage is slightly changed, the high-resolution A/D converter malfunctions in some cases, and this breaks a demodulator in the worst case.

In accordance with miniaturization of an integrated circuit (IC) in recent years, reduction of power consumption in a power supply of the A/D converter is also required. The sensitivity of the A/D converter is increased also by reducing a power supply voltage of the A/D converter, so that a resistance to contamination of noise and a resistance to flow of an electric current are also reduced by that amount. Therefore, an amplitude specification of an input signal required by the A/D converter in an amplifier tends to be reduced (allowable input voltage range is reduced).

In a case where such a demodulator that accepts an input signal having a small amplitude and a high frequency receiver that receives a high frequency signal having a large amplitude are connected to each other, there is a possibility that an amplitude of a signal outputted from the high frequency receiver exceeds an allowable amplitude amount of an input signal required by the demodulator. In a case where a maximum value of the amplitude of the signal outputted from the high frequency receiver is larger than an allowable amplitude value of the input signal allowable by the demodulator, there is a fear in that a property of the demodulator is deteriorated and the demodulator is broken.

Ordinarily, by performing automatic gain control (AGC) from the demodulator to the high frequency receiver, an amplitude of a signal outputted from the high frequency receiver is limited to an amplitude desired by the demodulator and the signal is then inputted to the demodulator. However, in a case where state transition of the AGC is slower than state transition of an output amplitude of the high frequency receiver, a limiting function is delayed, and therefore an amplitude larger than a desired amplitude is transiently inputted in some cases.

For example, Patent Literature 1 describes that a control speed of a closed-loop control circuit is changed based on information on a difference between an amplitude of a voltage control amplifier output signal for performing control for supplying a signal having a certain amplitude to a subsequent circuit such as a demodulation circuit and a predetermined reference amplitude. According to a technique described in Patent Literature 1, the control speed of the closed-loop control circuit is controlled to be increased when the amplitude of the voltage control amplifier output signal is increased. Therefore, a saturation error in rising of a signal amplitude does not occur, so that it is possible to reduce a possibility of saturation of the subsequent A/D converter.

Citation List

Patent Literature

Patent Literature 1: JP 2003-152479A

Summary of Invention

Technical Problem

However, in a case where the automatic gain control described in Patent Literature 1 is carried out, control of the control speed of the closed-loop control circuit is started when the amplitude of the voltage control amplifier output signal is increased, and therefore influence of noise or the like that is instantaneously contaminated cannot be completely prevented. In other words, in such feedback control, it is impossible to preclude a possibility of application of a voltage exceeding an absolute maximum rating of the A/D converter to the A/D converter.

Malfunction or breakage of the demodulator caused by contamination of noise or the like into the demodulator is also prevented by providing a protection element such as a diode between the high frequency receiver and an input terminal of the demodulator. However, in a case where the protection element is provided between the high frequency receiver and the input terminal of the demodulator, parts mounted on hardware are added. This increases production costs.

The present disclosure has been made in view of the above problems, and an object of the present disclosure is to securely limit an amplitude of a signal outputted from a high frequency receiver within an amplitude range allowable by the demodulator without adding new parts.

Solution to Problem

According to an embodiment of the present disclosure, there is provided a reception device including: a high-frequency reception processing unit; and an amplitude limiting unit, and a configuration and a function of each unit are as follows. The high-frequency reception processing unit converts a high frequency signal into an intermediate frequency signal or a baseband signal. The amplitude limiting unit limits a first amplitude to a second amplitude, the first amplitude being an amplitude of the intermediate frequency signal or the baseband signal outputted from the high-frequency reception processing unit, the second amplitude being an amplitude allowable in a demodulation unit that demodulates the intermediate frequency signal or the baseband signal.

According to an embodiment of the present disclosure, there is provided a reception method carried out in following steps. First, a high frequency signal is converted into an intermediate frequency signal or a baseband signal. Then, an amplitude limiting unit limits a first amplitude to a second amplitude, the first amplitude being an amplitude of the intermediate frequency signal or the baseband signal outputted from the high-frequency reception processing unit, the second amplitude being an amplitude allowable in a demodulation unit that demodulates the intermediate frequency signal or the baseband signal.

By configuring the reception device and performing the reception processing as described above, the amplitude of the intermediate frequency signal or the baseband signal inputted to the demodulation unit is limited within an amplitude range allowable in the demodulation unit.

Advantageous Effects of Invention

According to a reception device and a reception method of the present disclosure, an amplitude of an intermediate frequency signal or a baseband signal inputted to a demodulation unit is securely limited within an amplitude range allowable in the demodulation unit, and therefore it is possible to prevent deterioration in a demodulation property of the demodulation unit and breakage of a demodulator.

Brief Description of Drawings

[FIG. 1] FIG. 1 is a block diagram illustrating a configuration example of a reception device according to an embodiment of the present disclosure.
[FIG. 2] FIG. 2 is a block diagram illustrating a configuration example of a high-frequency reception unit according to an embodiment of the present disclosure.
[FIG. 3] FIG. 3 is a block diagram illustrating a configuration example of an amplitude limiting unit according to an embodiment of the present disclosure.
[FIG. 4] FIG. 4 is a circuit diagram illustrating a circuit configuration example of an amplitude limiting unit according to an embodiment of the present disclosure.
[FIG. 5] FIG. 5 is an explanatory view schematically illustrating a function of an amplitude limiting unit according to an embodiment of the present disclosure.
[FIG. 6] FIG. 6 is a block diagram illustrating a configuration example of a reception device according to a modification example of the present disclosure.

Description of Embodiments

An example of a circuit board according to an embodiment of the present disclosure will be described with reference to the appended drawings in the following order. Note that the present disclosure is not limited to the following examples. 1. CONFIGURATION EXAMPLE OF RECEPTION DEVICE 2. CONFIGURATION EXAMPLE OF HIGH-FREQUENCY RECEPTION UNIT 3. CONFIGURATION EXAMPLE OF AMPLITUDE LIMITING UNIT 4. VARIOUS MODIFICATION EXAMPLES

## <1. CONFIGURATION EXAMPLE OF RECEPTION DEVICE>

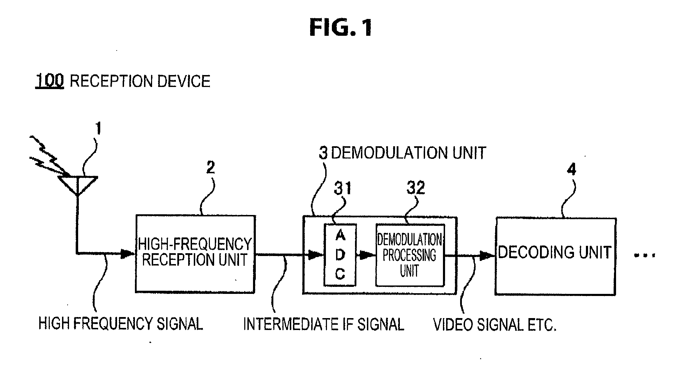

A reception device according to an embodiment of the present disclosure will be described with reference to FIG. 1. FIG. 1 is a block diagram illustrating a configuration example of a reception device 100 according to this embodiment. The reception device 100 includes a high-frequency reception unit 2 that converts a high frequency signal received by an antenna 1 into an intermediate frequency signal (hereinafter, referred to as "intermediate IF signal"), a demodulation unit 3 that demodulates the intermediate IF signal and outputs a transport stream (TS) signal, and a decoding unit 4 that decodes the TS signal into a video signal and a sound signal.

Note that this embodiment describes an example where the reception device 100 receives a broadcast signal of terrestrial digital television broadcasting, however, this embodiment is not limited thereto. This embodiment is also applicable to reception devices for receiving other broadcast waves of digital satellite broadcasting, cable television broadcasting, and the like. The reception device 100 is also applicable to a reception device for receiving a signal other than the broadcast waves.

## <2. CONFIGURATION EXAMPLE OF HIGH FREQUENCY RECEPTION UNIT>

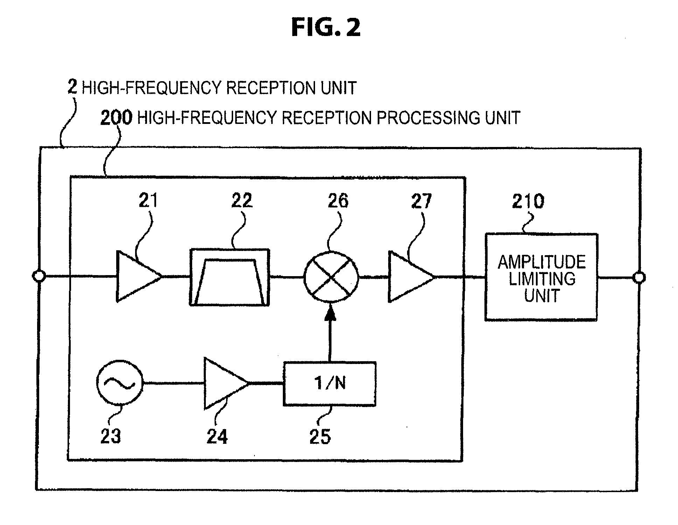

An internal configuration example of the high-frequency reception unit 2 will be described with reference to a block diagram of FIG. 2. The high-frequency reception unit 2 of this embodiment includes a high-frequency reception processing unit 200 and an amplitude limiting unit 210. The high-frequency reception processing unit 200 includes a low noise amplifier (LNA) 21, a band-pass filter 22, a voltage controlled oscillator (VCO) 23, an amplifier 24, a frequency divider 25, a mixer 26, and an amplifier 27.

The LNA 21 amplifies a high frequency signal obtained in the antenna 1 (see FIG. 1) and outputs the amplified high frequency signal to the band-pass filter 22. The band-pass filter 22 allows only a signal having a frequency around a desired reception frequency to be received to pass therethrough and outputs the signal to the mixer 26. The VCO 23 generates a frequency in accordance with a voltage applied from a phase comparator (not shown). The amplifier 24 amplifies the frequency generated in the VCO 23 and inputs the amplified frequency to the frequency divider 25. The frequency divider 25 divides the frequency generated in the VCO 23 and amplified in the amplifier 24 into 1/N and outputs the divided frequency. Feedback control is carried out in a phase-locked loop (PLL) circuit including the VCO 23, the amplifier 24, and the frequency divider 25, and therefore the frequency outputted from the frequency divider 25 is higher than the reception frequency by an amount of an IF frequency.

The mixer 26 mixes the frequency inputted from the frequency divider 25 with the frequency of the reception signal passed through the band-pass filter 22 to thereby generate an intermediate IF signal, and outputs the generated intermediate IF signal to the amplifier 27. The amplifier 27 amplifies the intermediate IF signal and outputs the amplified intermediate IF signal to the amplitude limiting unit 210.

## <3. CONFIGURATION EXAMPLE OF AMPLITUDE LIMITING UNIT>

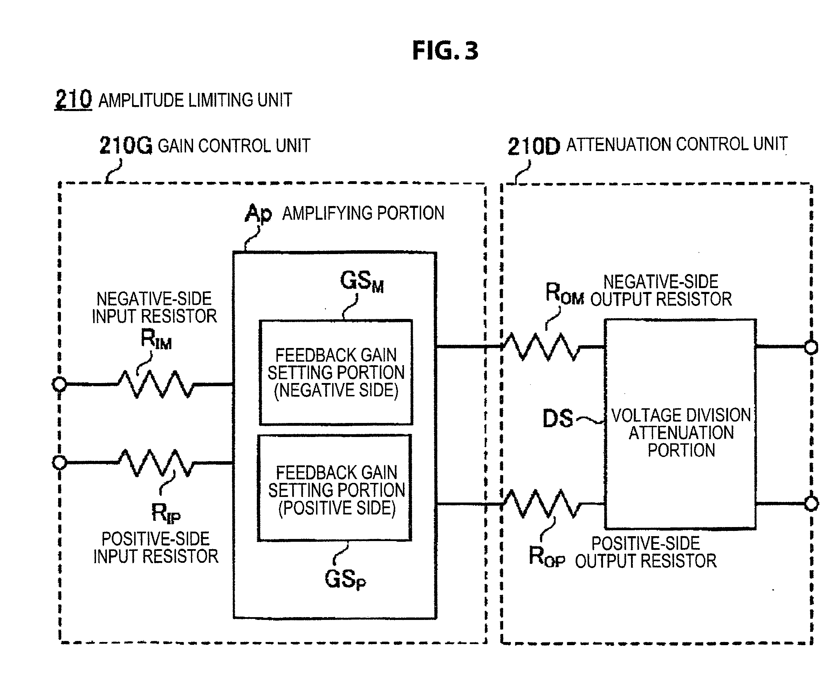

FIG. 3 is a principle view schematically illustrating a function of the amplitude limiting unit 210. The amplitude limiting unit 210 includes a gain control unit 210G that amplifies a gain of the inputted intermediate IF signal to a predetermined level and an attenuation control unit 210D that attenuates the intermediate IF signal amplified in the gain control unit 210G.

The gain control unit 210G includes an amplifying portion Ap including an operational amplifier. The amplifying portion Ap includes a feedback gain setting portion $GS_M$ that sets a gain of a signal having an amplitude in a negative direction, the signal being inputted via a negative-side input resistor $R_{IM}$, and a feedback gain setting portion $GS_P$ that sets a gain of a signal having an amplitude in a positive direction, the signal being inputted via a positive-side input resistor $R_{IP}$. The feedback gain setting portion $GS_M$ and the feedback gain setting portion $GS_P$ are configured as variable resistors. The gain of the signal having the amplitude in the negative direction is determined by the negative-side input resistor $R_{IM}$ and the feedback gain setting portion $GS_M$, and the gain of the signal having the amplitude in the positive direction is determined by the positive-side input resistor $R_{IP}$ and the feedback gain setting portion $GS_P$.

A terminal that outputs the signal having the amplitude in the negative direction is connected to a negative-side output resistor $R_{OM}$, and a terminal that outputs the signal having the amplitude in the positive direction is connected to a positive-side output resistor $R_{OP}$. A transmission line of a signal passed through the negative-side output resistor $R_{OM}$ and a transmission line of a signal passed through the positive-side output resistor $R_{OP}$ are connected to a voltage-dividing attenuation portion DS.

The voltage-dividing attenuation portion DS is configured as a variable resistor, and the other end thereof is grounded. The voltage-dividing attenuation portion DS configured as described above attenuates a level of the gain amplified in the gain control unit 210G to a level matched with an allowable amplitude amount of an A/D converter 31 (see FIG. 1) in the demodulation unit 3.

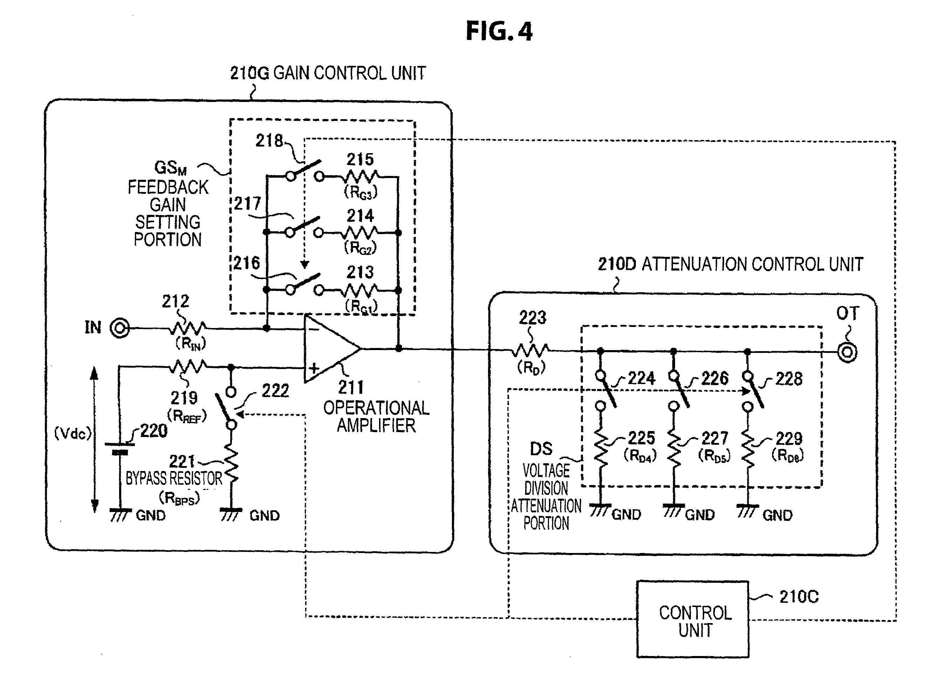

A circuit configuration example of the amplitude limiting unit 210 will be described with reference to FIG. 4. Note that, in the configuration illustrated as the principle view in FIG. 3, FIG. 4 only illustrates a configuration of units that determine a gain or an attenuation amount of a signal having a negative-side amplitude and does not illustrate a configuration that determines a gain or an attenuation amount of a signal having a positive-side amplitude.

First, a configuration of the gain control unit 210G of the amplitude limiting unit 210 will be described. The gain control unit 210G includes an operational amplifier 211, and an negative-side input terminal of the operational amplifier 211 is connected to an input terminal IN of a signal via an input resistor 212. The intermediate IF signal outputted from the high-frequency reception processing unit 200 (see FIG. 2) is inputted to the input terminal IN.

A resistor 213, a resistor 214, and a resistor 215, each of which is a feedback resistor, are connected in parallel to one another between the negative-side input terminal and an output terminal of the operational amplifier 211. The resistor 213, the resistor 214, and the resistor 215 are connected to a switch 216, a switch 217, and a switch 218 each of which switches on/off connection of the corresponding resistor. The resistors 213 to 215 and the switches 216 to 218 constitute the feedback gain setting portion $GS_M$ illustrated in FIG. 3. The resistor 213, the resistor 214, and the resistor 215 have feedback resistance values $R_{G1}$, $R_{G2}$, and $R_{G3}$, respectively. On/off of the switch 216, the switch 217, and the switch 218 is switched based on control by a control unit 210C including a central processing unit (CPU) and the like.

A gain of the operational amplifier 211 is determined based on a ratio of a synthesized resistance value $R_{GN}$ ("$_N$" is a natural number) of the resistors that are in a connection state among the resistor 213, the resistor 214, and the resistor 215 constituting the feedback gain setting portion $GS_M$ to an input resistance value $R_{IN}$ of the input resistor. For example, a gain of the operational amplifier 211 in a state in which the switch 216 is on and the resistor 213 (feedback resistance value $R_{G1}$) is selected is calculated by a calculation expression "feedback resistance value $R_{G1}$ / input resistance value $R_{IN}$".

A positive-side input terminal of the operational amplifier 211 is connected to a reference direct-current power supply 220 having a voltage Vdc via an input resistor 219 having a resistance value $R_{REF}$. A bypass resistor 221 having a resistance value $R_{BPS}$ (hereinafter, also referred to as "bypass resistance value $R_{BP}$"), one end of which is connected to a ground potential portion (GND), is connected between the input resistor 219 and the positive-side input terminal of the operational amplifier 211 via the switch 222. On/off control of the switch 222 is also carried out by the control unit 210C. Note that the direct-current voltage Vdc of the reference direct-current power supply 220 is generated by dividing a power supply voltage Vcc of the reception device 100, and is generally set to a voltage lower than the power supply voltage Vcc.

In a case where the switch 222 is off, a direct-current bias voltage obtained by "direct-current voltage Vdc $\times$ 1 / resistance value $R_{REF}$" is applied to the positive-side input terminal of the operational amplifier 211. Meanwhile, in a case where the switch 222 is on, a direct-current bias voltage obtained by "direct-current voltage Vdc $\times$ bypass resistance value $R_{BPS}$ / (resistance value $R_{REF}$ + bypass resistance value $R_{BPS}$)" is applied to the positive-side input terminal of the operational amplifier 211. In a case where no signal is inputted to the negative-side input terminal of the operational amplifier 211, any one of those voltages appears at the output terminal of the operational amplifier 211. In other words, an alternating current signal that shifts in the positive or negative direction from the direct-current bias voltage applied to the positive-side input terminal of the operational amplifier 211 is outputted from the output terminal of the operational amplifier 211.

Herein, by setting the bypass resistance value $R_{BPS}$ of the bypass resistor 221 to a value satisfying the following expression 1, a terminal voltage of the positive input terminal of the operational amplifier 211 in a case of selecting the bypass resistor 221 can be less than the direct-current voltage Vdc.

$$\text{Power supply voltage Vcc} \times \text{bypass resistance value } R_{BPS} / (\text{bypass resistance value } R_{BPS} + \text{resistance value } R_{REF}) \dots \text{Expression 1}$$

By setting the bypass resistance value $R_{BPS}$ as described above and then performing control for connecting the bypass resistor 221 at the time of, for example, starting a circuit of the reception device 100, a terminal voltage of a positive-side negative terminal of the operational amplifier 211 at the time of starting the circuit is always less than the direct-current voltage Vdc. At the time of starting the circuit of the reception device 100, an electric current flown through each circuit constituting the reception device 100 tends to be small and a voltage induced in an input terminal of each circuit also tends to be high. According to the present disclosure, even in this state, the terminal voltage (direct-current bias voltage) of the positive-side negative terminal of the operational amplifier 211 can be smaller than the direct-current voltage Vdc. The control for connecting the bypass resistor 221 is cancelled after a predetermined time period is passed from the start of the circuit or after rising of the circuit is stable.

The attenuation control unit 210D will be described. The attenuation control unit 210D includes a direct-current resistor 223 connected to the output terminal of the operational amplifier 211 of the gain control unit 210G. The attenuation control unit 210D also includes a voltage dividing resistor 225 selectively connected to a GND via a switch 224, a voltage dividing resistor 227 selectively connected to a GND via a switch 226, and a voltage dividing resistor 229 selectively connected to a GND via a switch 228. The voltage dividing resistor 225, the voltage dividing resistor 227, and the voltage dividing resistor 229 have voltage-dividing resistance values $R_{D1}$, $R_{D2}$, and $R_{D3}$, respectively. The voltage dividing resistor 225, the voltage dividing resistor 227, the voltage dividing resistor 229, the switch 224, the switch 226, and the switch 228 constitute the voltage-dividing attenuation portion DS illustrated in FIG. 3. On/off control of the switch 224, the switch 226, and the switch 228 is carried out by the control unit 210C.

The intermediate IF signal whose gain has been controlled by the gain control unit 210G is inputted to the attenuation control unit 210D. An attenuation amount (voltage dividing ratio) of the signal attenuated in the attenuation control unit 210D is determined based on a ratio of a synthesized resistance value $RD_N$ ("$_N$" is a natural number) of the resistors that are in a connection state among the voltage dividing resistor 225, the voltage dividing resistor 227, and the voltage dividing resistor 229 constituting the voltage-dividing attenuation portion DS to a direct-current resistance value $R_D$ of the direct-current resistor. For example, an attenuation amount in a state in which the switch 224 is on and the voltage dividing resistor 225 (voltage-dividing resistance value $R_{D1}$) is selected is calculated by a calculation expression "resistance value $R_{D1}$ / (resistance value $R_D$ + resistance value $R_{D1}$)".

In other words, by selecting or not selecting the voltage dividing resistor 225, the voltage dividing resistor 227, and the voltage dividing resistor 229 constituting the voltage-dividing attenuation portion DS of the attenuation control unit 210D, the attenuation amount (upper limit value of a voltage appearing at an output terminal OT) of the signal can be set to an arbitrary value. By regulating the attenuation amount in the attenuation control unit 210D, the amplitude of the signal to be inputted to the A/D converter 31 (see FIG. 1) in the demodulation unit 3 connected as a subsequent unit can be reduced to fall within an allowable amplitude value range of the A/D converter 31.

By attenuating the signal in the attenuation control unit 210D, the amplitude of the intermediate IF signal superimposed on the direct-current voltage outputted from the operational amplifier 211 is also limited, however, a level of the intermediate IF signal can be stabilized by amplifying an amount corresponding to this attenuation in the gain control unit 210G.

From the above description, it is understood that a transfer characteristic TC of the whole amplitude limiting unit 210 can be calculated by the following expression 2.

Transfer characteristic TC = resistance value $R_{G1}$ / input resistance value $R_{IN}$ × voltage-dividing resistance value $R_{D1}$ / (direct-current resistance value $R_D$ + voltage-dividing resistance value $R_{D1}$) ... Expression 2

That is, according to above embodiment example, by combining the direct-current voltage, which is calculated by "direct-current bias voltage Vdc × voltage-dividing resistance value $R_{DN}$ / (direct-current resistance value $R_D$ + voltage-dividing resistance value $R_{DN}$)", and an alternating current gain, which is calculated by "feedback resistance value $R_{GN}$ / input resistance value $R_{IN}$ × voltage-dividing resistance value $RD_N$ / (direct-current resistance value $R_D$ + voltage-dividing resistance value $R_{DN}$)", a dynamic range of an output voltage can be set to a desired range.

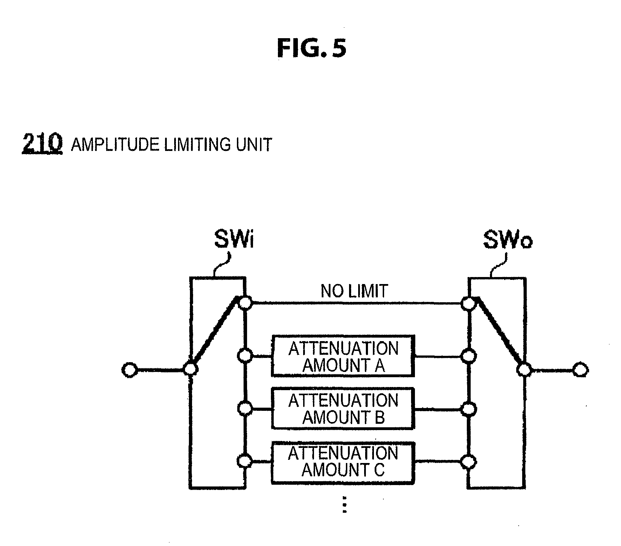

Such control by the amplitude limiting unit 210 is schematically illustrated in FIG. 5. Specifically, by switching the switch $SW_I$ and the switch $SW_O$, the amplitude limiting unit 210 according to this embodiment example can freely switches an attenuation amount A, an attenuation amount B, and an attenuation amount C having different values in accordance with an allowable amplitude value of the subsequent demodulation unit 3. Note that, as illustrated in FIG. 5, an option "no limit" may be selected. For example, in order to select the option "no limit" in the configuration illustrated in FIG. 4, another resistor is added to the feedback gain setting portion $GS_M$ in parallel and is connected, and all the switches 224, 226, and 228 are switched off in the attenuation control unit 210D. With this configuration, it is possible to optimally connect the high-frequency reception processing unit 200 to the demodulation unit 3 even in a case where an amplitude of a signal outputted from the high-frequency reception processing unit 200 of the reception device 100 is smaller than the allowable amplitude value of the demodulation unit 3.

Because such selection control of the attenuation amounts is carried out, the amplitude inputted to the A/D converter 31 can be reduced to fall within the allowable amplitude value range only by changing setting of the attenuation amounts regardless a value of the power supply voltage Vcc in the reception device 100. Therefore, it is unnecessary to prepare plural kinds of reception circuits (increase the model number of circuits) corresponding to kinds of power supply voltages Vcc of the reception device 100.

The operational amplifier 211 in the gain control unit 210G also has a dynamic range, and therefore, in a case where a voltage out of the dynamic range is applied, the output voltage of the operational amplifier 211 is saturated. In other words, even in a case where a high voltage is instantaneously inputted to the input terminal IN due to contamination or the like of a noise, a voltage of a signal outputted from the operational amplifier 211 always falls within the dynamic range of the operational amplifier. Therefore, it is possible to securely prevent a voltage exceeding the absolute maximum rating voltage of the A/D converter 31 from being applied to the input terminal of the subsequent A/D converter 31.

Further, according to above embodiment example, control for switching on the bypass resistor 221 of the gain control unit 210G at the time of starting the reception device 100 is carried out, and therefore the direct-current bias voltage at the time of starting the circuit is always less than the direct-current voltage Vdc. Thus, even in a time period during which the terminal voltage of the positive-side input terminal of the operational amplifier 211 at the time of starting the circuit differs from the voltage appearing at the output terminal of the operational amplifier 211 at the time of starting the circuit, the voltage appearing at the output terminal of the operational amplifier 211 can be kept low.

## <4. VARIOUS MODIFICATION EXAMPLES>

Note that the above embodiment describes an example where the three feedback resistors of the gain control unit 210G and the three voltage dividing resistors of the attenuation control unit 210D are provided, however, the embodiment is not limited to three feedback resistors and three voltage dividing resistors. For example, only a single feedback resistor and a single voltage dividing resistor may be provided, or four or more feedback resistors and four or more voltage dividing resistors may be provided. In a case where only a single feedback resistor and a single voltage dividing resistor are provided, by configuring a circuit having functions of the gain control unit 210G and the attenuation control unit 210D so that the circuit is removable from the reception device 100 and selecting the circuit in accordance with the allowable amplitude value of the A/D converter 31, various power supply voltages Vcc can be applied.

Further, the above embodiment describes an example where the direct-current bias voltage at the time of starting the circuit is reduced to be less than the direct-current voltage Vdc by using the bypass resistor 221; however, the embodiment is not limited thereto. For example, connection between the gain control unit 210G and the attenuation control unit 210D may be cut off by inserting an on/off switch between the output terminal of the operational amplifier 211 and the direct-current resistor 223 and switching off the on/off switch during a period from start of starting processing of the circuit to completion of the starting processing. At this time, by switching on any one of the switch 224, the switch 226, and the switch 228, the output terminal OT becomes a ground potential for direct current.

The attenuation amount may be dynamically set in a time direction in such a way that, for example, the attenuation amount attenuated in the amplitude limiting unit 210 is increased at the time of starting the circuit and the attenuation amount is decreased during an ordinary operation after completion of this starting operation. Also with this configuration, an effect similar to that of the above embodiment can be obtained.

The above embodiment describes an example where control of the output voltage is carried out by using the dynamic range of the operational amplifier 211; however, the embodiment is not limited thereto. A plurality of so-called limiter circuits corresponding to the number of attenuation amounts to be set may be provided and configured to be switched.

Note that the above embodiment describes an example where the antenna 1 of the reception device 100 receives a broadcast wave of terrestrial digital broadcasting and the high-frequency reception processing unit 200 performs detection with a super-heterodyne method, however, the embodiment is not limited thereto. The embodiment may be applied to a configuration in which satellite digital broadcasting or the like is received with a direct conversion method.

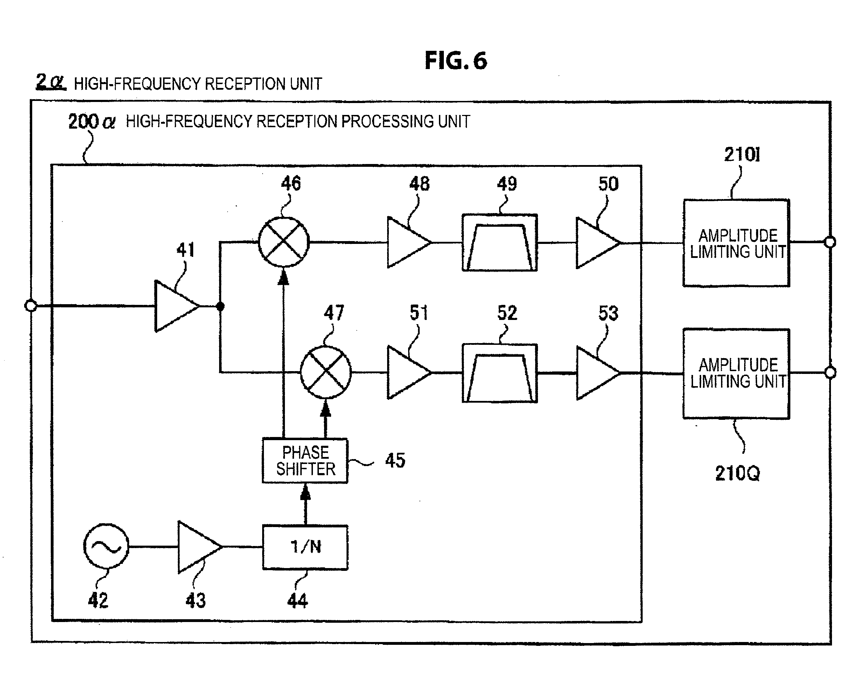

FIG. 6 is a block diagram illustrating a configuration example of a high-frequency reception unit $2\alpha$ in a case where detection is carried out with the direct conversion method. The high-frequency reception unit $2\alpha$ includes a high-frequency reception processing unit $200\alpha$, an amplitude limiting unit 210I, and an amplitude limiting unit 210Q. The high-frequency reception processing unit $200\alpha$ includes an LNA 41, a VCO 42, an amplifier 43, a frequency divider 44, a phase shifter 45, mixers 46 and 37, amplifiers 48 and 41, band-pass filters 49 and 42, and amplifiers 50 and 53.

The LNA 41 amplifies a high frequency signal obtained in the antenna 1 (see FIG. 1) and outputs the amplified high frequency signal to the mixers 46 and 37. The VCO 42 generates a frequency in accordance with a voltage applied from a phase comparator (not shown). The amplifier 53 amplifies the frequency generated in the VCO 42 and inputs the amplified frequency to the frequency divider 44. The frequency divider 44 divides the frequency generated in the VCO 42 and amplified in the amplifier 53 into 1/N and outputs the divided frequency. The phase shifter 45 generates two output signals (signals whose phases are shifted by 90°) orthogonal to each other and supplies the two output signals to the mixer 46 and the mixer 47.

The mixer 46 generates an I signal by mixing the reception signal amplified in the LNA 41 with the signal outputted from the phase shifter 45 and outputs the I signal to the amplifier 48. The mixer 47 generates a Q signal by mixing the reception signal amplified in the LNA 41 with the signal outputted from the phase shifter 45 and outputs the Q signal to the amplifier 51. The I signal amplified in the amplifier 48 passes through the band-pass filter 49 to be limited within a predetermined frequency band, is amplified in the amplifier 50, and is supplied to the amplitude limiting unit 210I. The Q signal amplified in the amplifier 51 passes through the band-pass filter 52 to be limited within a predetermined frequency band, is amplified in the amplifier 53, and is supplied to the amplitude limiting unit 210Q. Functions of the amplitude limiting unit 210I and the amplitude limiting unit 210Q are same as those of the amplitude limiting unit 210, and therefore description thereof is herein omitted.

Additionally, the present technology may also be configured as below.

(1) A reception device including:

a high-frequency reception processing unit that converts a high frequency signal into an intermediate frequency signal or a baseband signal; and

an amplitude limiting unit that limits a first amplitude to a second amplitude, the first amplitude being an amplitude of the intermediate frequency signal or the baseband signal outputted from the high-frequency reception processing unit, the second amplitude being an amplitude allowable in a demodulation unit that demodulates the intermediate frequency signal or the baseband signal.

(2) The reception device according to (1),
wherein the demodulation unit includes an analog/digital converting unit that converts the intermediate frequency signal or the baseband signal into a digital signal, and the second amplitude is an amplitude allowable in the analog/digital converting unit.

(3) The reception device according to (1) or (2),
wherein the amplitude control unit includes an attenuation control unit that controls a magnitude of the second amplitude by switching at least two attenuation amounts having different values.

(4) The reception device according to any one of (1) to (3),
wherein the amplitude control unit includes a gain control unit that controls a gain of the intermediate frequency signal or the baseband signal outputted from the high-frequency reception processing unit and outputs the intermediate frequency signal or the baseband signal whose gain has been controlled to the attenuation control unit.

(5) The reception device according to any one of (1) to (4),
wherein the gain control unit includes an operational amplifier to which the intermediate frequency signal or the baseband signal is inputted, and an excessive output part of the first amplitude exceeding a saturation output voltage of the operational amplifier is limited within a range of the saturation output voltage.

(6) The reception device according to (5),
wherein the attenuation control unit includes a direct-current resistor connected to an output terminal of the operational amplifier of the gain control unit, and at least two voltage dividing resistors selectively connected between the direct-current resistor and the output terminal of the intermediate frequency signal or the baseband signal and between the direct-current resistor and a ground potential portion, and the at least two attenuation amounts for use in control of the magnitude of the second amplitude are controlled by selecting or not selecting the at least two voltage dividing resistors.

(7) The reception device according to any one of (1) to (6), further including:

a control unit,
wherein the gain control unit includes an input resistor connected between the input terminal to which the intermediate frequency signal or the baseband signal is inputted and a negative-side output terminal of the operational amplifier, and at least two gain control resistors selectively connected between a negative-side input terminal of the operational amplifier and the output terminal of the operational amplifier, and
wherein the control unit controls a control amount of the gain by selecting or not selecting the at least two gain control resistors.

(8) The reception device according to any one of (5) to (7),
wherein a bypass resistor that is selectively switched between connection and nonconnection to the ground potential portion is connected between a reference direct-current power supply connected to the negative-side input terminal of the operational amplifier and the negative-side input terminal, and
wherein the control unit sets the bypass resistor to be in a connection state at the time of starting the reception device.

(9) The reception device according to any one of (1) to (7), further including:

an on/off switch that switches a connection state between the gain control unit and the attenuation control unit,

wherein the control unit performs control in a manner that the on/off switch is turned off in a state in which the connection state of the bypass resistor is switched to be in a connection state at the time of starting the reception device.

(10) A reception method including:

extracting converting a high frequency signal received by an antenna into an intermediate frequency signal or a baseband signal; and

limiting a first amplitude to a second amplitude, the first amplitude being an amplitude of the intermediate frequency signal or the baseband signal, the second amplitude being an amplitude allowable in a demodulation unit that demodulates the intermediate frequency signal or the baseband signal.

Reference Signs List

| | |
|---|---|
| 1 | antenna |
| 2 | high-frequency reception unit |
| 3 | demodulation unit |
| 4 | decoding unit |
| 21 | LNA |
| 22 | band-pass filter |
| 23 | VCO |
| 24 | amplifier |
| 25 | frequency divider |
| 26 | mixer |
| 27 | amplifier |
| 31 | A/D converter |
| 41 | LNA |
| 42 | VCO |
| 43 | amplifier |
| 44 | frequency divider |
| 45 | phase shifter |
| 46 | mixer |
| 47 | mixer |
| 48 | amplifier |
| 49 | band-pass filter |
| 50 | amplifier |
| 51 | amplifier |
| 52 | band-pass filter |
| 53 | amplifier |
| 100 | reception device |
| 200 | high-frequency reception processing unit |
| 210 | amplitude limiting unit |
| 210C | control unit |
| 210D | attenuation control unit |
| 210G | gain control unit |
| 210I | amplitude limiting unit |
| 210Q | amplitude limiting unit |
| 211 | operational amplifier |
| 212 | input resistor |
| 213 to 215 | resistor |
| 216 to 218 | switch |
| 219 | input resistor |
| 220 | reference direct-current power supply |
| 221 | bypass resistor |
| 222 | switch |
| 223 | direct-current resistor |
| 224 | switch |
| 225 | voltage dividing resistor |
| 226 | switch |

**Claims**

1. A reception device comprising:

   a high-frequency reception processing unit that converts a high frequency signal into an intermediate frequency signal or a baseband signal; and
   an amplitude limiting unit that limits a first amplitude to a second amplitude, the first amplitude being an amplitude of the intermediate frequency signal or the baseband signal outputted from the high-frequency reception processing unit, the second amplitude being an amplitude allowable in a demodulation unit that demodulates the intermediate frequency signal or the baseband signal.

2.  The reception device according to claim 1,
    wherein the demodulation unit includes an analog/digital converting unit that converts the intermediate frequency signal or the baseband signal into a digital signal, and the second amplitude is an amplitude allowable in the analog/digital converting unit.

3.  The reception device according to claim 2,
    wherein the amplitude limiting unit includes an attenuation control unit that controls a magnitude of the second amplitude by switching at least two attenuation amounts having different values.

4.  The reception device according to claim 3,
    wherein the amplitude limiting unit includes a gain control unit that controls a gain of the intermediate frequency signal or the baseband signal outputted from the high-frequency reception processing unit and outputs the intermediate frequency signal or the baseband signal whose gain has been controlled to the attenuation control unit.

5.  The reception device according to claim 4,
    wherein the gain control unit includes an operational amplifier to which the intermediate frequency signal or the baseband signal is inputted, and an excessive output part of the first amplitude exceeding a saturation output voltage of the operational amplifier is limited within a range of the saturation output voltage.

6.  The reception device according to claim 5,
    wherein the attenuation control unit includes a direct-current resistor connected to an output terminal of the operational amplifier of the gain control unit, and at least two voltage dividing resistors selectively connected between the direct-current resistor and the output terminal of the intermediate frequency signal or the baseband signal and between the direct-current resistor and a ground potential portion, and the at least two attenuation amounts for use in control of the magnitude of the second amplitude are controlled by selecting or not selecting the at least two voltage dividing resistors.

7.  The reception device according to claim 6, further comprising:

    a control unit,
    wherein the gain control unit includes an input resistor connected between the input terminal to which the intermediate frequency signal or the baseband signal is inputted and a negative-side output terminal of the operational amplifier, and at least two feedback resistors selectively connected between a negative-side input terminal of the operational amplifier and the output terminal of the operational amplifier, and
    wherein the control unit controls a control amount of the gain by selecting or not selecting the at least two feedback resistors.

8.  The reception device according to claim 7,
    wherein a bypass resistor that is selectively switched between connection and nonconnection to the ground potential portion is connected between a reference direct-current power supply connected to the negative-side input terminal of the operational amplifier and the negative-side input terminal, and
    wherein the control unit sets the bypass resistor to be in a connection state at the time of starting the reception device.

9.  The reception device according to claim 7, further comprising:

    an on/off switch that switches a connection state between the gain control unit and the attenuation control unit,
    wherein the control unit performs control in a manner that the on/off switch is turned off in a state in which the connection state of the bypass resistor is switched to be in a connection state at the time of starting the reception device.

10.  A reception method comprising:

    converting a high frequency signal into an intermediate frequency signal or a baseband signal; and
    limiting a first amplitude to a second amplitude, the first amplitude being an amplitude of the intermediate frequency signal or the baseband signal, the second amplitude being an amplitude allowable in a demodulation unit that demodulates the intermediate frequency signal or the baseband signal.

# FIG. 1

100 RECEPTION DEVICE

1

2

3 DEMODULATION UNIT

31

32

4

HIGH-FREQUENCY
RECEPTION UNIT

A
D
C

DEMODULATION
PROCESSING
UNIT

DECODING UNIT

...

HIGH FREQUENCY SIGNAL

INTERMEDIATE IF SIGNAL

VIDEO SIGNAL ETC.

# FIG. 2

2 HIGH-FREQUENCY RECEPTION UNIT

200 HIGH-FREQUENCY RECEPTION PROCESSING UNIT

# FIG. 3

<u>210</u> AMPLITUDE LIMITING UNIT

<u>210G</u> GAIN CONTROL UNIT

<u>210D</u> ATTENUATION CONTROL UNIT

Ap AMPLIFYING PORTION

$GS_M$

NEGATIVE-SIDE
INPUT RESISTOR

$R_{IM}$

FEEDBACK GAIN
SETTING PORTION
(NEGATIVE SIDE)

$R_{IP}$

POSITIVE-SIDE
INPUT RESISTOR

FEEDBACK GAIN
SETTING PORTION
(POSITIVE SIDE)

$GS_P$

$R_{OM}$ NEGATIVE-SIDE
OUTPUT RESISTOR

DS

VOLTAGE DIVISION
ATTENUATION
PORTION

$R_{OP}$
POSITIVE-SIDE
OUTPUT RESISTOR

EP 2 887 544 A1

**FIG. 4**

210G GAIN CONTROL UNIT

$GS_M$ FEEDBACK GAIN SETTING PORTION

218
217
216

215 ($R_{G3}$)
214 ($R_{G2}$)
213 ($R_{G1}$)

IN ◎

212 ($R_{IN}$)

219 ($R_{REF}$)
222

211 OPERATIONAL AMPLIFIER

($V_{dc}$)

220
221 BYPASS RESISTOR ($R_{BPS}$)

GND    GND

210D ATTENUATION CONTROL UNIT

223 ($R_D$)

OT ◎

224    226    228

DS VOLTAGE DIVISION ATTENUATION PORTION

225 ($R_{D4}$)    227 ($R_{D5}$)    229 ($R_{D6}$)

GND    GND    GND

210C

CONTROL UNIT

EP 2 887 544 A1

# FIG. 5

**210** AMPLITUDE LIMITING UNIT

SWi                       SWo

NO LIMIT

ATTENUATION
AMOUNT A

ATTENUATION
AMOUNT B

ATTENUATION
AMOUNT C

# FIG. 6

*2α* HIGH-FREQUENCY RECEPTION UNIT

*200α* HIGH-FREQUENCY RECEPTION PROCESSING UNIT

- 41
- 46
- 48
- 49
- 50
- 210I AMPLITUDE LIMITING UNIT
- 47
- 51
- 52
- 53
- 210Q AMPLITUDE LIMITING UNIT
- PHASE SHIFTER 45
- 1/N 44
- 42
- 43

EP 2 887 544 A1

**INTERNATIONAL SEARCH REPORT**

International application No.

PCT/JP2013/069119

A. CLASSIFICATION OF SUBJECT MATTER
*H03G3/30*(2006.01)i, *H03G3/20*(2006.01)i, *H04N5/44*(2011.01)i

According to International Patent Classification (IPC) or to both national classification and IPC

B. FIELDS SEARCHED

Minimum documentation searched (classification system followed by classification symbols)
H03G3/30, H03G3/20, H04N5/44

Documentation searched other than minimum documentation to the extent that such documents are included in the fields searched
Jitsuyo Shinan Koho      1922-1996   Jitsuyo Shinan Toroku Koho   1996-2013
Kokai Jitsuyo Shinan Koho   1971-2013   Toroku Jitsuyo Shinan Koho   1994-2013

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2006-109154 A  (Matsushita Electric Industrial Co., Ltd.), 20 April 2006 (20.04.2006), paragraphs [0008] to [0044]; fig. 1 (Family: none) | 1-10 |
| Y | JP 8-214447 A  (Nikon Corp.), 20 August 1996 (20.08.1996), paragraphs [0009] to [0031]; fig. 1 (Family: none) | 1-10 |
| Y | JP 2005-123998 A  (Murata Mfg. Co., Ltd.), 12 May 2005 (12.05.2005), paragraphs [0016] to [0031]; fig. 1 to 3 (Family: none) | 3-9 |

☒ Further documents are listed in the continuation of Box C.   ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30 August, 2013 (30.08.13) | 10 September, 2013 (10.09.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2013/069119 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2006-332994 A  (Mitsumi Electric Co., Ltd.),<br>07 December 2006 (07.12.2006),<br>paragraphs [0014] to [0033]; fig. 1, 2<br>(Family: none) | 8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003152479 A